# EUROPEAN PATENT APPLICATION

(11) **EP 4 611 046 A1**
(43) Date of publication of application: **03.09.2025**
(21) Application number: 23881466.9
(22) Date of filing: 04.09.2023
(51) Int. Cl.: H01L 31/05, H01L 31/0224, H01L 31/18

(54) **CONNECTION STRUCTURE AND METHOD FOR SOLAR CELL STRING**

(30) Priority: 28.10.2022 CN 202211335990
(71) Applicant: Trina Solar Co., Ltd, Changzhou, Jiangsu 213031 (CN)
(72) Inventor: CHU, Haiyuan, hangzhou, Jiangsu 213031 (CN); ZHANG, Shu, hangzhou, Jiangsu 213031 (CN); YANG, Zemin, hangzhou, Jiangsu 213031 (CN); WANG, Le, hangzhou, Jiangsu 213031 (CN)
(74) Representative: Arnold & Siedsma
(86) International application number: PCT/CN2023/116743
(87) International publication number: WO 2024/087885

(57) **Abstract**

The present application relates to a connection structure and method for a solar cell string. The connection structure comprises solar cells (1), solder strips (2), adhesive points (3), grid fingers (4), and electrical connection lines (5). The adhesive points (3) and the grid fingers (4) are respectively arranged on the surfaces of the solar cells (1), the solder strips (2) are pre-fixed to the solar cells (1) by means of the adhesive points (3), and the solder strips (2) are electrically connected to the plurality of grid fingers (4); the electrical connection lines (5) are connected to the plurality of grid fingers (4).

## Description

### CROSS-REFERENCE TO RELATED APPLICATIONS

This application claims priority to Chinese Patent Application No. 202211335990.5, entitled "SOLAR CELL STRING CONNECTION STRUCTURE AND SOLAR CELL STRING CONNECTION METHOD", filed on October 28, 2022, the content of which is incorporated herein by reference in its entirety.

### TECHNICAL FIELD

The present application relates to the field of photovoltaic technologies, and in particular, to a solar cell string connection structure and a solar cell string connection method.

### BACKGROUND

As countries around the world accelerate energy transition, a proportion of photovoltaics in clean energy continues to rise. Photovoltaic paste accounts for about 50% of a non-silicon cost of a solar cell. Reducing unit consumption of silver paste will be an important direction for technological innovation.

A busbar is designed in a current conventional photovoltaic cell, which mainly serves to electrically and mechanically connect a solder strip. That is, the solder strip is fixed to the solar cell through the busbar, and the current is collected and transferred to the solder strip. Generally, the busbar is printed with silver paste. With popularity of multi-busbar solar cells, unit consumption of the silver paste of the busbar is also gradually increasing. There is a need to reduce unit consumption of the busbar through some new solutions.

### SUMMARY

In a first aspect, according to various embodiments of the present application, a solar cell string connection structure is provided.

The present application provides a solar cell string connection structure, including: a solar cell, a solder strip, an adhesive point, a finger, and an electrical connection wire.

The adhesive point and the finger are respectively arranged on a surface of the solar cell. The solder strip is pre-fixed to the solar cell through the adhesive point. The solder strip is electrically connected to a plurality of fingers.

The electrical connection wire is connected to the plurality of fingers.

In an embodiment, the adhesive point is a conductive adhesive point.

The adhesive point is located on the finger. The finger provided with the adhesive point is connected to the electrical connection wire.

In an embodiment, at least one adhesive point is a conductive adhesive point.

The adhesive point is located between two adjacent fingers. At least one of the fingers on two sides of the adhesive point is connected to the electrical connection wire.

In an embodiment, the adhesive point is an insulating adhesive point.

The adhesive point is located on the finger. The finger provided with the adhesive point is connected to the electrical connection wire.

In an embodiment, the adhesive point is an insulating adhesive point.

The adhesive point is located between two adjacent fingers. At least one of the fingers on two sides of the adhesive point is connected to the electrical connection wire.

In an embodiment, two ends of the electrical connection wire are respectively connected to the fingers on the two sides of the adhesive point.

In an embodiment, one of the fingers on the two sides of the adhesive point is connected, through the electrical connection wire, to the adjacent finger on a same side and located further outside.

In an embodiment, the fingers on the two sides of the adhesive point are connected, through the electrical connection wire, respectively, to the respective adjacent fingers on respective same sides and located further outside.

In an embodiment, the fingers on the two sides of the adhesive point are connected to each other through the electrical connection wire. One of the fingers on the two sides of the adhesive point is connected, through the electrical connection wire, to the adjacent finger on a same side and located further outside.

In an embodiment, the fingers on the two sides of the adhesive point are connected to each other through the electrical connection wire. The fingers on the two sides of the adhesive point are connected, through the electrical connection wire, respectively, to the respective adjacent fingers on respective same sides and located further outside.

In an embodiment, the finger provided with the adhesive point is connected, through the electrical connection wire, to the adjacent finger on one side.

In an embodiment, the finger provided with the adhesive point is connected, through the electrical connection wire, respectively, to the adjacent fingers on two sides of the adhesive point.

In an embodiment, a distance d1 between the adhesive point and each of the fingers on the two sides of the adhesive point is no less than 0.1 mm.

In an embodiment, a straight line where the electrical connection wire is located intersects with the adhesive point and is completely covered by the solder strip.

In an embodiment, a straight line where the electrical connection wire is located is staggered from the adhesive point. A distance d2 between the electrical connection wire and the adhesive point is less than or equal to 1/2 of a projected distance d3 between two adjacent adhesive points in an extending direction of the finger.

In an embodiment, a width W1 of the adhesive point is greater than or equal to a width W2 of the finger, and a length L1 of the adhesive point is greater than or equal to a width W3 of the solder strip.

In an embodiment, a projected length L4 of the electrical connection wire in a direction perpendicular to the finger is greater than or equal to a minimum distance between two adjacent fingers. The projected length L4 is less than or equal to a maximum distance L3 between two outermost fingers.

In a second aspect, according to various embodiments of the present application, a solar cell string connection method is further provided.

The solar cell string connection method uses the solar cell string connection structure as described above. The solar cell string connection method includes, subsequent to adhesive application point and prior to lamination:
pre-bonding the solder strip to the solar cell through the adhesive point;
curing the adhesive point; and
soldering a connection body formed by the solar cell, the solder strip, and the adhesive point, so that the solder strip is in an alloyed contact with the finger.

In an embodiment, the curing includes: illumination and hot pressing.

In an embodiment, the soldering includes: infrared welding, hot air welding, and induction heating, and a soldering temperature ranges from 130°C to 300°C.

In an embodiment, the curing is completed during the soldering, or the curing is carried out in a preheating stage of the soldering.

### BRIEF DESCRIPTION OF THE DRAWINGS

In order to more clearly illustrate the technical solutions in embodiments of the present application or the conventional art, the accompanying drawings used in the description of the embodiments or the conventional art will be briefly introduced below. It is apparent that, the accompanying drawings in the following description are only for some embodiments of the present application, and other drawings can be obtained by those of ordinary skill in the art from the disclosed drawings without creative efforts.
FIG. 1 is a schematic structural view of a solar cell string according to an embodiment of the present application;
FIG. 2 is a schematic view of a distance between an adhesive point and a finger according to an embodiment of the present application;
FIG. 3 is a schematic structural view of electrical connection wires in various forms according to an embodiment of the present application;
FIG. 4 is a schematic structural view of electrical connection wires away from the adhesive point according to an embodiment of the present application;
FIG. 5 is a schematic structural view of a solar cell string connection structure according to an embodiment of the present application;
FIG. 6 is a schematic structural view showing a length of the electrical connection wire according to an embodiment of the present application; and
FIG. 7 is a flowchart of a solar cell string connection method according to an embodiment of the present application.

Illustration for reference signs:
1: solar cell, 2: solder strip, 3: adhesive point, 4: finger, 5: electrical connection wire.

### DETAILED DESCRIPTION

The technical solutions in the embodiments of the present application will be described clearly and completely below with reference to the accompanying drawings in the embodiments of the present application. Obviously, the described embodiments are merely some of rather than all of the embodiments of the present application. All other embodiments acquired by those of ordinary skill in the art without creative efforts based on the embodiments of the present application shall fall within the protection scope of the present application.

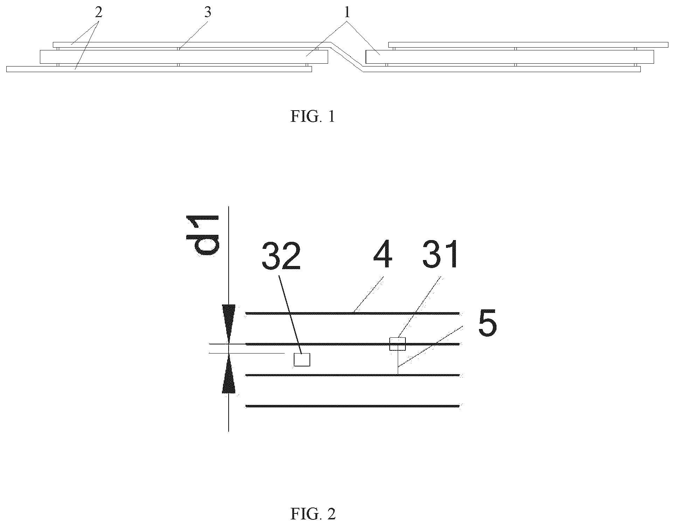

A solar cell string connection structure provided in the embodiments of the present application includes a solar cell 1, a solder strip 2, an adhesive point 3, a finger 4, and an electrical connection wire 5. A structure of the solar cell string connection structure may be shown in FIG. 1, FIG. 5, and FIG. 6.

The adhesive point 3 and the finger 4 are respectively arranged on a surface of the solar cell 1. The solder strip 2 is pre-fixed to the solar cell 1 through the adhesive point 3. The solder strip 2 is electrically connected to a plurality of fingers 4. It may be understood that after pre-fixing, the adhesive point 3 is also required to be cured.

The electrical connection wire 5 is connected to the plurality of fingers 4.

As can be seen from the above technical solution, according to the solar cell string connection structure provided in the embodiments of the present application, the electrical connection wire 5 is designed at the finger 4, which provides another channel between the fingers 4 to transfer current to the solder strip 2. When the finger 4 and the solder strip 2 are not in an effective contact with each other, the electrical connection wire 5 may transfer the current to the finger 4 connected thereto, and then the current is transferred to the solder strip 2, or the current may be directly transferred to the solder strip 2 by the electrical connection wire 5, which reduces a risk of poor contact caused by overflow of the adhesive point 3 onto the finger 4. In the scheme, no busbar is required, which reduces unit consumption of silver paste of the solar cell and reduces the cost of the solar cell. Subsequent to adhesive application and prior to lamination, the solder strip is directly soldered, so that a solder is melted and is in a good alloyed contact with the grids of the solar cell, and the solder is not melted again during the lamination, which reduces a risk of infiltration of the adhesive film into a gap between the solder strip and the solar cell.

The adhesive used for the adhesive point 3 may be either an adhesive with a conductive capability or an insulating adhesive with no conductive capability. For the conductive adhesive, since the adhesive can conduct the current, the adhesive application position is relative to the position of the finger 4 on the surface of the solar cell 1, preferably, is on the finger 4. In this case, the current on the finger 4 can be directly transferred to the solder strip 2 through the conductive adhesive point 3. The structure thereof may be shown in FIG. 2. A first adhesive point 31 with a conductive capability is located on the finger 4. The finger 4 provided with the first adhesive point 31 is connected to the electrical connection wire 5.

The conductive adhesive point 3 may alternatively be located between two adjacent fingers 4. The structure thereof may be referred to a second adhesive point 32 shown in FIG. 2, and the adhesive mainly plays a connecting role in this case. At least one of the fingers 4 on two sides of the second adhesive point 32 is connected to the electrical connection wire 5, which reduces a risk of poor contact caused by overflow of the second adhesive point 32 onto the finger 4.

The adhesive with no conductive capability may also be applied to the finger 4, but the finger 4 is required to be led out to the electrical connection wire 5, so that the current on the finger 4 can be conducted normally. The structure thereof may be shown in FIG. 2. The insulating first adhesive point 31 is located on the finger 4. The finger 4 provided with the first adhesive point 31 is connected to the electrical connection wire 5.

The non-conductive adhesive point 3 may preferably be located between two adjacent fingers 4. The structure thereof may be referred to the second adhesive point 32 shown in FIG. 2. At least one of the fingers 4 on two sides of the second adhesive point 32 is connected to the electrical connection wire 5.

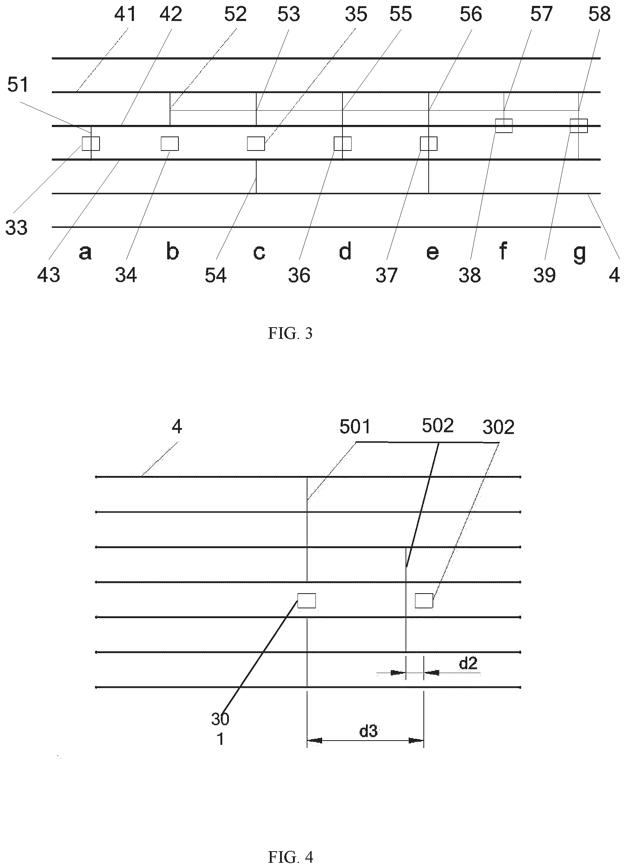

Specifically, in an embodiment, two ends of a first electrical connection wire 51 are respectively connected to a second finger 42 and a third finger 43 on two sides of a third adhesive point 33, as shown by *a* form a in FIG. 3.

In another embodiment, one (the second finger 42 herein) of the second finger 42 and the third finger 43 that are on two sides of a fourth adhesive point 34 is connected, through a second electrical connection wire 52, to an adjacent first finger 441 on the same side and located further outside, as shown by a form *b* in FIG. 3.

In still another embodiment, the second finger 42 and the third finger 43 that are on two sides of a fifth adhesive point 35 are connected, through a third electrical connection wire 53 and a fourth electrical connection wire 54, respectively, to the corresponding adjacent first finger 41 and a corresponding adjacent fourth finger 44 that are on the respective same sides and located further outside, as shown by a form c in FIG. 3.

In yet another embodiment, the second finger 42 and the third finger 43 that are on two sides of a sixth adhesive point 36 are connected to each other through a fifth electrical connection wire 55; and one (the second finger 42 herein) of the second finger 42 and the third finger 43 that are on the two sides of the sixth adhesive point 36 is connected, through the fifth electrical connection wire 55, to the adjacent first finger 41 on the same side and located further outside, as shown by a form *d* in FIG. 3

Additionally/alternatively, in a further embodiment, the second finger 42 and the third finger 43 that are on two sides of a seventh adhesive point 37 are connected to each other through a sixth electrical connection wire 56; and the second finger 42 and the third finger 43 that are on the two sides of the seventh adhesive point 37 are connected, through the sixth electrical connection wire 56, respectively, to the corresponding adjacent first finger 41 and the corresponding adjacent fourth finger 44 on the respective same sides and located further outside, as shown by a form e in FIG. 3.

In another embodiment, the second finger 42 provided with an eighth adhesive point 38 is connected, through a seventh electrical connection wire 57, to the adjacent first finger 41 on one side, as shown by a form *f* in FIG. 3.

In another embodiment, the second finger 42 provided with a ninth adhesive point 39 is connected, through an eighth electrical connection wire 58, respectively, to the adjacent first finger 41 and the adjacent third finger 43 on two sides, as shown by a form g in FIG. 3.

To prevent overflow of the second adhesive point 32 onto the finger 4, a distance d1 between the second adhesive point 32 and each of the fingers 4 on the two sides of the second adhesive point 32 is no less than 0.1 mm. The structure thereof may be shown in FIG. 2.

In a preferable embodiment, a straight line where the electrical connection wire 5 is located intersects with the adhesive point 3. The structure thereof may be referred to an intersecting adhesive point 301 shown in FIG. 4 and is completely covered by the solder strip 2, as shown in FIG. 4. In this case, an intersecting electrical connection wire 501 may not additionally shade light and can increase output power of the component.

In another embodiment, since the electrical connection wire 5 is soldered below the solder strip 2, there may be a certain risk of soldering detachment. A design in which the electrical connection wire 5 is away from the adhesive point 3 may alternatively be adopted: a straight line where the staggered electrical connection wire 502 is located is staggered from a staggered adhesive point 302; and a horizontal distance d2 between the staggered electrical connection wire 502 and the staggered adhesive point 302 is less than or equal to 1/2 of a projected distance d3 between two adjacent adhesive points 3 (the intersecting adhesive point 301 and the staggered adhesive point 302 herein) in an extending direction of the finger 4. The structure thereof may be shown in FIG. 4.

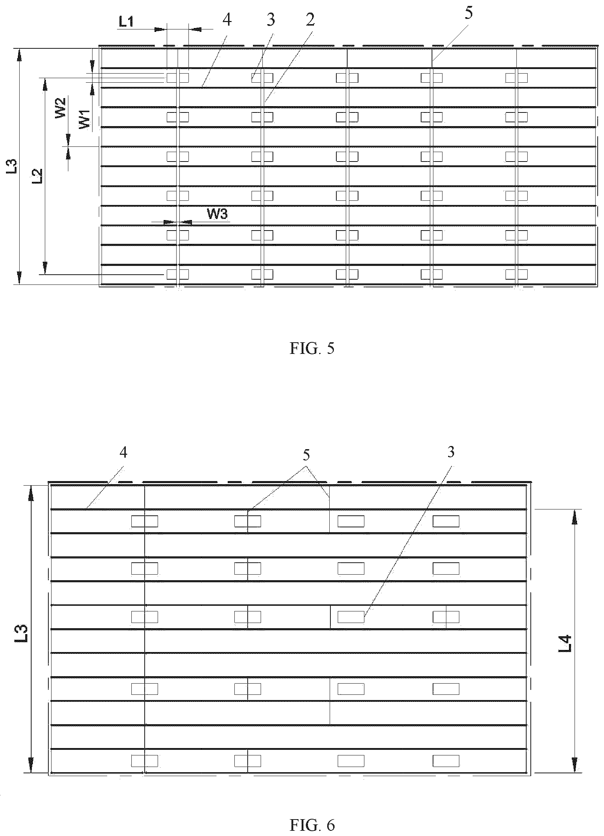

Further, a width W1 of the adhesive point 3 is greater than or equal to a width W2 of the finger 4, and a length L1 of the adhesive point 3 is greater than or equal to a width W3 of the solder strip 2, to ensure a bonding force. The structure thereof may be shown in FIG. 5. A distance L2 between centers of two outermost adhesive points is not greater than a distance L3 between two outermost fingers, as shown in FIG. 5.

Preferably, a projected length L4 of the electrical connection wire 5 in a direction perpendicular to the finger 4 is greater than or equal to a minimum distance between two adjacent fingers 4. The projected length L4 is less than or equal to the maximum distance L3 between two outermost fingers 4. The structure thereof may be shown in FIG. 6.

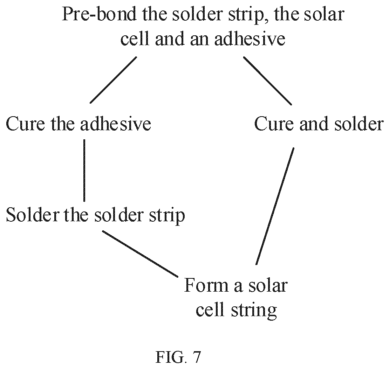

Embodiments of the present application further provide a method, using the solar cell string connection structure as described above. The solar cell string connection method includes, subsequent to adhesive application point and prior to lamination:
pre-bonding the solder strip 2 to the solar cell 1 through the adhesive points 3;
curing the adhesive point 3; and
soldering a connection body formed by the solar cell 1, the solder strip 2, and the adhesive point 3, so that the solder strip 2 and the finger 4 are in an alloyed contact. A flow thereof may be shown in FIG. 7.

As can be seen from the above technical solution, according to the solar cell string connection method provided in the embodiments of the present application, the electrical connection wire 5 is designed at the finger 4, which provides other channels between the fingers 4 to transfer the current to the solder strip 2. When the finger 4 and the solder strip 2 are not in an effective contact, the electrical connection wire 5 may transfer the current to the finger 4 connected thereto, and then the current is transferred to the solder strip 2, or the current may be directly transferred to the solder strip 2 by the electrical connection wire 5, which reduces a risk of poor contact caused by overflow of the adhesive point 3 onto the finger 4. In the scheme, no busbar is required, which reduces unit consumption of silver paste of the solar cell and reduces the cost of the solar cell. Subsequent to adhesive application and prior to lamination, the solder strip is directly soldered, so that a solder is melted and is in a good alloyed contact with the grids of the solar cell, and the solder is not melted again during the lamination, which reduces a risk of infiltration of the adhesive film into a gap between the solder strip and the solar cell.

Preferably, the curing includes: illumination and hot pressing. After the adhesive is cured, the solder strip 2 and the solar cell 1 may be in a connection with a more stable strength.

Specifically, the soldering includes: infrared welding, hot air welding, and induction heating. A soldering temperature ranges from 130°C to 300°C. An electrical connection between the finger and the solder strip is formed.

Further, when the adhesive used may be cured by heat, the curing of the adhesive may be carried out in the same process as the soldering. That is, the curing is completed during the soldering, or the adhesive is cured in a preheating stage of the soldering.

The scheme is further introduced below with reference to specific embodiments.

The present application discloses a solar cell string connection structure and a solar cell string connection method. The solar cell string includes a plurality of solar cells connected in series, in which two adjacent solar cells are connected to each other through a solder strip, an adhesive to fix the finger and the solar cell. On the surface of the solar cell, the solar cell is pre-bonded to the solder strip by applying the adhesive to specified positions on the solar cell and/or the solder strip, as shown in FIG. 1.

In order to ensure that the solder strip can be effectively bonded to the solar cell, no less than two adhesive application points are provided corresponding to a single solder strip of a single solar cell, the number of the adhesive application points is not greater than the number of the fingers of the solar cell. To ensure the bonding force, the width W1 of the adhesive is greater than or equal to the width W2 of the finger, and the length L1 of the adhesive is greater than or equal to the width W3 of the solder strip. The distance L2 between centers of two outermost adhesive application points is not greater than the distance L3 between two outermost fingers, as shown in FIG. 5.

The adhesive used may be either an adhesive with a conductive capability or an insulating adhesive with no conductive capability. For the conductive adhesive, since the adhesive can conduct the current, the adhesive application position is relative to the position of the finger on the surface of the solar cell, preferably is on the finger. The current on the finger can be directly transferred to the solder strip through the conductive adhesive. The adhesive application position may alternatively be between two fingers, and the adhesive mainly plays a connecting role in this case. The non-conductive adhesive is preferably between two fingers, and in order to prevent overflow onto the finger, a distance between an edge of the adhesive and the finger is no less than 0.3 mm. The non-conductive adhesive may alternatively be applied to the finger, but this finger is required to be led out to the connection wire, so that the current on the finger can be conducted normally, as shown in FIG. 2.

Since the adhesive has a certain height, performance of contact between the finger adj acent to the adhesive and the solder strip is weaker than that in a region without the adhesive. In addition, the adhesive further has a certain degree of fluidity and may overflow to the adjacent finger, which may also affect contact between the adjacent finger and the solder strip. In this case, another channel is required to transfer the current onto the solder strip. In a manner, as shown in FIG. 3, a finger electrical connection wire is provided, which electrically connects the finger adjacent to the adhesive point to another finger. When the adjacent finger is not in an effective contact with the solder strip, the electrical connection wire may transfer the current to the finger connected thereto, and then the current is transferred to the solder strip, or the current may be directly transferred to the solder strip by the electrical connection wire. At at least one adhesive position, at least one finger adjacent thereto is connected to at least one other finger through the finger connection wire. *a-e* shown in FIG. 3 illustrate some embodiments of electrical connections between two fingers in an adhesive application region relative to the solar cell. With respect to the adhesive application position, the electrical connection wire at *a* shown in FIG. 3 connects two fingers adjacent to the adhesive application position; at b shown in FIG. 3, the electrical connection wire connects one adjacent finger to one non-adjacent finger; at c shown in FIG. 3, the electrical connection wire connects two fingers adjacent to the adhesive application position to two non-adjacent fingers, respectively; at d shown in FIG. 3, the electrical connection wire connects two fingers adjacent to the adhesive application position to the same non-adjacent finger; at e shown in FIG. 3, the electrical connection wire connects two fingers adjacent to the adhesive application position and connects two non-adjacent fingers. *f*-*g* shown in FIG. 3 illustrate embodiments in which the adhesive application region is on the finger of the solar cell relative to the solar cell. At *f* shown in FIG. 3, the finger where the adhesive application position is located is connected to one adjacent finger. At g shown in FIG. 3, the finger where the adhesive application position is located is connected to two adjacent fingers.

As shown in FIG. 6, to further reduce the risk of poor contact between the solder strip and the finger, the adjacent finger may be connected to more other fingers, and a projected length L4 of the electrical connection wire in the direction perpendicular to the finger is not greater than a spacing L3 between two fingers on an outer edge of the solar cell. The finger electrical connection wire preferably intersects with the adhesive application position and is completely covered by the solder strip. In this case, the electrical connection wire may not additionally shade light and can increase output power of the component. Since the electrical connection wire is soldered below the solder strip, there may be a certain risk of soldering detachment. A design in which the electrical connection wire is away from the adhesive application position may alternatively be adopted. The distance d2 is not greater than 1/2 of the projected distance d3 between two adjacent adhesive dispensing positions in a direction parallel to the finger.

After the solar cell is pre-bonded to the solder strip through adhesive, the adhesive is cured. The curing includes illumination, hot pressing, and the like. After the adhesive is cured, the solder strip and the solar cell may be in a connection with more stable strength.

After a stable connection is formed, a connection body formed by the solar cell, the solder strip, and the adhesive are soldered by a soldering machine, so that the solder strip is in an alloyed contact with the finger, and an electrical connection between the finger and the solder strip is formed. The soldering includes infrared welding, hot air welding, induction heating, and the like. A soldering temperature ranges from 130°C to 300°C.

When the adhesive used may be cured by heat, the curing of the adhesive may be carried out in the same process as the soldering. That is, the curing is completed during the soldering or the adhesive is cured in a preheating stage of the soldering.

After the soldering, the solar cell and the solder strip form a stable mechanical connection through the adhesive, and the solder strip and the finger form an electrical connection through soldering, thereby forming a solar cell string with stable electrical and mechanical connections.

In the scheme, subsequent to adhesive application and prior to lamination, the solder strip is directly soldered so that a solder is melted and is in a good alloyed contact with the grids of the solar cell, and the solder is not melted again during the lamination, which reduces a risk of infiltration of the adhesive film into a gap between the solder strip and the solar cell.

Moreover, the scheme further provides a graphic design of a solar cell with adhesive application positions. To reduce the risk of poor contact caused by overflow of the adhesive onto the finger, a finger electrical connection wire is designed on the finger adjacent to the adhesive application position.

Based on the above, embodiments of the present application disclose the solar cell string connection structure and the solar cell string connection method. The solar cell and the solder strip are pre-bonded by adhesive. In a direction parallel to the solder strip, a plurality of adhesive application positions are provided. Two or more adhesive application points at each solder strip of each solar cell may be provided, and the number of the adhesive application points is less than or equal to the number of fingers on a cell unit. At least one of the fingers adjacent to one adhesive application point is provided with the electrical connection wire. The finger is connected to another finger through the connection wire. The length of the connection wire is not less than a vertical distance between the two fingers and is not greater than the distance between two outermost fingers.

After the solar cell and the solder strip are pre-bonded by adhesive, the adhesive is cured. After the curing, the solder strip and the solar cell are in a good mechanical connection. The connection body is soldered. After the soldering, the solder strip and the finger/electrical connection wire of the solar cell are in an electrical connection, thereby forming a final solar cell string. The curing of the adhesive may alternatively be carried out simultaneously with the soldering. That is, the curing of the adhesive is completed simultaneously at the soldering temperature.

Compared with the prior art, the present application achieves the following beneficial effects.
1. Unit consumption of silver paste of the solar cell is reduced, and the cost of the solar cell is reduced.
2. Reliability of the connection between the solder strip and the solar cell is improved.

Various embodiments in the specification are described progressively. Each embodiment focuses on differences from other embodiments. Same and similar parts among the embodiments may be referred to one another.

The foregoing descriptions of the disclosed embodiments enable those skilled in the art to implement or adopt the present application. Multiple modifications to these embodiments are apparent for those skilled in the art. The general principle defined herein may be implemented in other embodiments without departing from the spirit or scope of the present application. Therefore, the present application is not limited to the embodiments described herein, but extends to the widest scope that complies with the principle and novelty disclosed herein.

The technical features in the above embodiments may be randomly combined. For concise description, not all possible combinations of the technical features in the above embodiments are described. However, all the combinations of the technical features are to be considered as falling within the scope described in this specification provided that they do not conflict with each other.

The above embodiments only describe several implementations of the present application, and their description is specific and detailed, but cannot therefore be understood as a limitation on the patent scope of the present application. It should be noted that those of ordinary skill in the art may further make variants and improvements without departing from the conception of the present application, and these all fall within the protection scope of the present application. Therefore, the patent protection scope of the present application shall be subject to the appended claims.

## Claims

1. A solar cell string connection structure, comprising: a solar cell (1), a solder strip (2), an adhesive point (3), a finger (4), and an electrical connection wire (5);
wherein the adhesive point (3) and the finger (4) are respectively arranged on a surface of the solar cell (1); the solder strip (2) is pre-fixed to the solar cell (1) through the adhesive point (3); and the solder strip (2) is electrically connected to a plurality of fingers (4); and
the electrical connection wire (5) is connected to the plurality of fingers (4).

2. The solar cell string connection structure according to claim 1, wherein the adhesive point (3) is a conductive adhesive point (3); and
the adhesive point (3) is located on the finger (4), and the finger (4) provided with the adhesive point (3) is connected to the electrical connection wire (5).

3. The solar cell string connection structure according to claim 1, wherein at least one adhesive point (3) is a conductive adhesive point (3); and
the adhesive point (3) is located between two adjacent fingers (4), and at least one of the fingers (4) on two sides of the adhesive point (3) is connected to the electrical connection wire (5).

4. The solar cell string connection structure according to claim 1, wherein the adhesive point (3) is an insulating adhesive point (3); and
the adhesive point (3) is located on the finger (4), and the finger (4) provided with the adhesive point (3) is connected to the electrical connection wire (5).

5. The solar cell string connection structure according to claim 1, wherein the adhesive point (3) is an insulating adhesive point (3); and
the adhesive point (3) is located between two adjacent fingers (4), and at least one of the fingers (4) on two sides of the adhesive point (3) is connected to the electrical connection wire (5).

6. The solar cell string connection structure according to claim 3 or 5, wherein two ends of the electrical connection wire (5) are respectively connected to the fingers (4) on the two sides of the adhesive point (3).

7. The solar cell string connection structure according to claim 3 or 5, wherein one of the fingers (4) on the two sides of the adhesive point (3) is connected, through the electrical connection wire (5), to the adjacent finger (4) on a same side and located further outside.

8. The solar cell string connection structure according to claim 3 or 5, wherein the fingers (4) on the two sides of the adhesive point (3) are connected, through the electrical connection wire (5), respectively, to the respective adjacent fingers (4) on respective same sides and located further outside.

9. The solar cell string connection structure according to claim 3 or 5, wherein the fingers (4) on the two sides of the adhesive point (3) are connected to each other through the electrical connection wire (5), and one of the fingers (4) on the two sides of the adhesive point (3) is connected, through the electrical connection wire (5), to the adjacent finger (4) on a same side and located further outside.

10. The solar cell string connection structure according to claim 3 or 5, wherein the fingers (4) on the two sides of the adhesive point (3) are connected to each other through the electrical connection wire (5), and the fingers (4) on the two sides of the adhesive point (3) are connected, through the electrical connection wire (5), respectively, to the respective adjacent fingers (4) on respective same sides and located further outside.

11. The solar cell string connection structure according to claim 2 or 4, wherein the finger (4) provided with the adhesive point (3) is connected, through the electrical connection wire (5), to the adjacent finger (4) on one side.

12. The solar cell string connection structure according to claim 2 or 4, wherein the finger (4) provided with the adhesive point (3) is connected, through the electrical connection wire (5), respectively, to the adjacent fingers (4) on two sides of the adhesive point (3).

13. The solar cell string connection structure according to claim 3 or 5, wherein a distance d1 between the adhesive point (3) and each of the fingers (4) on the two sides of the adhesive point (3) is no less than 0.1 mm.

14. The solar cell string connection structure according to claim 1, wherein a straight line where the electrical connection wire (5) is located intersects with the adhesive point (3) and is completely covered by the solder strip (2).

15. The solar cell string connection structure according to claim 1, wherein a straight line where the electrical connection wire (5) is located is staggered from the adhesive point (3); and a distance d2 between the electrical connection wire (5) and the adhesive point (3) is less than or equal to 1/2 of a projected distance d3 between two adjacent adhesive points (3) in an extending direction of the finger (4).

16. The solar cell string connection structure according to claim 1, wherein a width W1 of the adhesive point (3) is greater than or equal to a width W2 of the finger (4), and a length L1 of the adhesive point (3) is greater than or equal to a width W3 of the solder strip (2).

17. The solar cell string connection structure according to claim 1, wherein a projected length L4 of the electrical connection wire (5) in a direction perpendicular to the finger (4) is greater than or equal to a minimum distance between two adjacent fingers (4); and the projected length L4 is less than or equal to a maximum distance L3 between two outermost fingers (4).

18. A solar cell string connection method, using the solar cell string connection structure according to any one of claims 1 to 17, the solar cell string connection method comprising, subsequent to adhesive application point and prior to lamination:
pre-bonding the solder strip (2) to the solar cell (1) through the adhesive point (3);
curing the adhesive point (3); and
soldering a connection body formed by the solar cell (1), the solder strip (2), and the adhesive point (3), so that the solder strip (2) is in an alloyed contact with the finger (4).

19. The solar cell string connection method according to claim 18, wherein the curing comprises: illumination and hot pressing.

20. The solar cell string connection method according to claim 18, wherein the soldering comprises: infrared welding, hot air welding, and induction heating, and a soldering temperature ranges from 130°C to 300°C.

21. The solar cell string connection method according to claim 18, wherein the curing is completed during the soldering, or the curing is carried out in a preheating stage of the soldering.
